# EUROPEAN PATENT APPLICATION

(11) **EP 1 253 387 A1**
(43) Date of publication of application: **30.10.2002**
(21) Application number: 01306618.8
(22) Date of filing: 01.08.2001
(51) Int. Cl.: F25B 21/02, F25D 11/02

(54) **Storage box**

(30) Priority: 24.04.2001 KR 2001022074
(71) Applicant: SAMSUNG ELECTRONICS CO., LTD., Suwon-City, Kyungki-do (KR)
(72) Inventor: Park, Rae-Eun, Paldal-gu, Suwon-city, Kyungki-do (KR); Kwon, Jun-Hyoun, Songpa-Gu, Seoul (KR); Kim, Chang-Nyeun, Dongdaemun-Gu, Seoul (KR); Kim, Yoon-Young, Paldal-Gu, Suwon-City, Kyungki-Do (KR); Lee, Jae-Seung, Paldal-Gu, Suwon-City, Kyungki-Do (KR)
(74) Representative: Geary, Stuart Lloyd

(57) **Abstract**

A storage box comprising a housing (10) defining a first storage compartment (14) having a main thermoelectric element (20) associated therein and which is operable to cool the first storage compartment (14), is disclosed. The storage box also includes a second housing (50) defining a second storage compartment (52) which is disposed within the first storage compartment (14). The second storage compartment has a second thermoelectric element (60) associated with it and which is operable to cool the second storage compartment (52) to a temperature lower than the temperature of the first storage compartment (14).

## Description

The present invention relates to a storage box comprising a housing defining a first storage compartment having a main thermoelectric element associated therewith operable to cool the first storage compartment.

A conventional refrigerator is designed to feed cool air from an evaporator into storage compartments inside a housing, such as a freezer compartment and a refrigerator compartment, to keep food stored in them cool or frozen for a period of time. Conventional refrigerators have a limitation because they can only be used to keep food cool within the freezer and refrigerator compartments. Furthermore, they have a complicated construction because the refrigeration cycle requires a condenser, an evaporator and a compressor.

The aforementioned disadvantage with a conventional refrigerator has been alleviated by the provision of a storage box that incorporates a thermoelectric element or module which can be selectively operated so as to warm the interior of the cabinet in which the thermoelectric element is mounted in addition to cooling it.

The thermoelectric element or module is a thermal element or module is a thermal converter that relies on the Peltier effect. It is therefore also known as a Peltier element. It comprises two metal plates made from different materials which are joined together at two junctions to form a circuit. When a direct current is passed round the circuit, one junction gives off heat and is cooled whereas the other absorbs heat and becomes warm. This effect is reversible, i.e. if the current is reversed, the cool junction becomes warm and the hot junction becomes cool.

If the thermoelectric element is disposed such that one junction is positioned within the storage compartment of a storage box and the outside it, the Peltier effect can be used to cool or heat the compartment as desired by controlling the polarity of the DC voltage applied to the element, i.e. when a DC voltage is applied to the thermoelectric element such that heat is dissipated from the junction located in the compartment, the temperature of the compartment is increased. However, when the polarity of the DC voltage applied to the thermoelectric element is reversed, the junction in the compartment absorbs heat from the air to cool the interior of the compartment. Therefore, the storage box can be operated in a hot-storage mode or a cool-storage mode by controlling the polarity of the DC voltage applied to the thermoelectric element.

A disadvantage with the conventional storage box described above that it can only be used to cool the food stored in the compartment, as the thermoelectric element does not control the temperature sufficiently so that it becomes low enough to reach a temperature below freezing and thereby act as a freezer.

When the required temperature of the compartment of a storage box is -15°C and the outside temperature is about 30°C, the practical temperature difference between the two junctions of the thermoelectric element is about 62°C, as the additional heat generated by heat exchanging units at the two junctions must be added to the arithmetic temperature difference between the compartment temperature and the outside temperature. Therefore, the cooling effect of the thermoelectric element is intrinsically reduced in inverse pr portion to the temperature difference between the two junctions. Therefore, it is impossible for a conventional cooling system, using a thermoelectric element, to keep the temperature of a storage compartment at about -15°C when the outside temperature is about 30°C.

A storage box according to the present invention is characterised by a second housing defining a second storage compartment disposed within the first storage compartment and having a second thermoelectric element associated therewith operable to cool the second storage compartment to a temperature lower than the temperature of the first storage compartment.

Preferably, the second thermoelectric element is operable to cool the second storage compartment to a temperature which is lower than zero degrees centigrade.

In a preferred embodiment, a heat dissipating unit is mounted on the outside of the second housing within the first housing to dissipate heat from the second storage compartment into the first storage compartment.

A fan is advantageously mounted adjacent to the heat dissipating unit to assist in the transfer of heat from the heat dissipating unit into the first storage compartment.

Preferably, the thermoelectric element is a Peltier element.

Conventionally, the second housing is removably mounted in the first housing.

The first and second housings are advantageously provided with a dedicated control unit to enable independent operation and control of the temperature within each housing.

Embodiments of the present invention will now be described by way of example only, with reference to the accompanying drawings, in which:
Figure 1 is a side section view showing the construction of a storage box using a thermoelectric element in accordance with the present invention;
Figure 2 is a perspective view of the storage box shown in Figure 1, showing how a sub-storage unit within the storage box may be removed therefrom;
Figure 3 is a enlarged view of a proportion of "A" in Figure 2;
Figure 4 is a perspective view of a storage box showing an alternative arrangement to enable a sun-storage showing an alternative arrangement to enable a sub-storage unit within the storage box to be removed therefrom; and
Figure 5 is a block diagram showing the construction of the storage box according to the present invention.

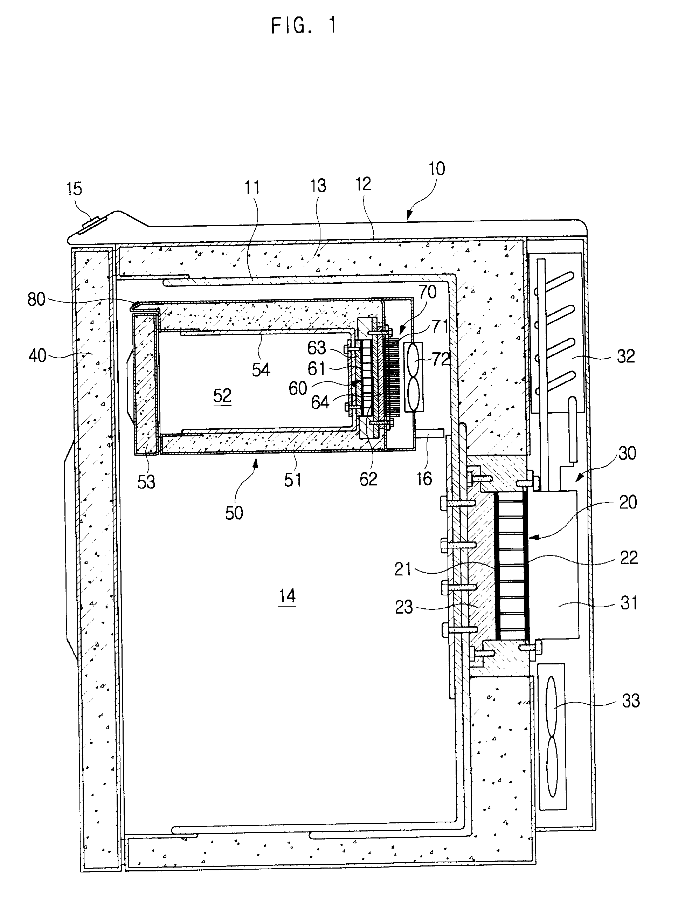

As shown in Figure 1, the storage box comprises a box-shaped cabinet or housing 10 defining a main or first storage compartment 14. A door 40 is hinged to the cabinet 10 to enable access to the main compartment 14 to be obtained. The storage box also has a small-sized sub-storage unit 50 disposed within the main compartment 14, and the interior of this unit can be kept below freezing temperature through a multi-stage cooling operation when the main compartment 14 is used as a refrigerator.

The cabinet 14 includes an inner casing 11 and an outer casing 12 separated by an insulation wall 13 formed from urethane foam. A main thermoelectric element 20 is mounted in the rear wall if the cabinet 10 between the inner and outer casing 11, 12 and performs heat absorption and heat dissipation at its two junctions. The inner casing 11 is preferably manufactured from aluminium which increases the thermal conductivity of the main thermoelectric element 20. A control panel 15, having a variety of control buttons to enable operation of a temperature control program, is provided at the top of the cabinet 10.

The main thermoelectric element 20 is a thermal converter that relies on the Peltier effect, as explained above. When an electric current is applied to a semiconductor (or a conductor) of the main thermoelectric element 20 in one direction, the first junction 21 of the thermoelectric element 20 is cooled, while the second junction 22 is heated. If the direction current is reversed, the first junction is heated and the second junction 22 is cooled. The first junction 21 is positioned in contact with the inner case 11 through a heat transfer block 23, so that it controls the temperature of the main compartment 14. The second junction 22 is positioned such that is exposed to the atmosphere. The main thermoelectric element 20 comprises two types of dissimilar thermoelectric semiconductors: a plurality of n-type and p-type thermoelectric semiconductors alternately arranged along a longitudinal axis of the thermoelectric element 20 joined together into a single body at two junctions. When an electric current is applied to the main thermoelectric element 20 in one direction, the two junctions of the two types of semiconductors absorb and dissipate heat, respectively. When the direction of the electric current applied to the thermoelectric element 20 is changed, the junction that was originally absorbing heat now dissipates it and the junction that was dissipating heat now absorbs it. The main compartment 14 of the storage box is thus usable as a cool-storage compartment or a hot-storage compartment as desired.

A heat dissipating unit 30, using a thermosiphon, is installed on the rear portion of the cabinet 10 and dissipates heat from the second junction 22 of the thermoelectric element 20 during a cool-storage mode operation of the storage box. The heat dissipating unit 30 contacts the second junction 22 of the thermoelectric element 20 and comprises an evaporator 31 for evaporating working fluid to make gas-phase working fluid, a condenser 32 for condensing the gas-phase working fluid fed from the evaporator 31 to make liquid-phase working fluid, and a cooling fan 33 which improves the condensing efficiency if the condenser 32. The condenser 32 is positioned higher than the evaporator 31, and is connected to the evaporator 31 through a working fluid pipe to form a closed circuit. During operation of the storage box, heat dissipated from the second junction 22 is transferred to the evaporator 31, thus evaporating the working fluid in the evaporator 31 to make gas-phase working fluid. The gas-phase working fluid is fed from the evaporator 31 to the condenser 32, thus being condensed to become liquid-phase working fluid prior to being returned to the evaporator 31.

The sub-storage unit 50 has a sub or second thermoelectric element which also has two junctions which either absorbs heat or dissipate it depending on the direction of current flow, thereby enabling the sub-storage unit 50 to reach freezing temperature when the main compartment 14 is being used as a refrigerator. The sub-storage unit 50 consists of a body 51, which defines a sub-storage or second sub-storage or second storage compartment 52 for storing food therein. A door 53 is hinged to the front of the body 51 to enable access to the sub-compartment 52 to be obtained. A heat dissipating unit 70 is installed in the sub-storage unit 50 adjacent to the heat dissipating junction of the sub-thermoelectric element 60 such that the heat dissipating unit 70 is outside the body 51.

A heat exchanging panel 54 is arranged on the inner surface of the sub-compartment 14 and is in contact with the first junction 61 of the sub-thermoelectric element 60 through a front heat transfer block 63. The first junction 61 of the thermoelectric element 60 acts as a heat absorbing junction during a frozen-storage mode operation of the unit 50.

The heat dissipating unit 70 is installed in the rear portion of the body 51 and is in contact with the second junction 62 of the sub-thermoelectric element 60 through a rear heat transfer block 64. The second junction 62 acts as a heat dissipating junction during the frozen-storage mode operation of the unit 50. The heat dissipating unit 70 acts as a heat sink and is fabricated with a plurality of cooling fins 71. A fan 72 is mounted adjacent to the fins 71 to improve the operational efficiency of the heat dissipating unit 70 by feeding air from the main compartment 14 to the heat dissipating unit 70 to dissipate heat to the air. The air in the main compartment 14 is actively and continuously circulated by the fan 72, so that it maintains a uniform temperature distribution throughout the compartment 14.

During operation of the sub-storage unit 50, the heat dissipating unit 70 dissipates heat into the main compartment 14. As the capacity of the main thermoelectric element 20 is higher than that of the sub-thermoelectric element 60, an undesirable increase in the temperature of the main compartment 14, irrespective of the heat dissipation from the heat dissipating unit 70 to the main compartment 14, can be prevented. Furthermore, a uniform temperature distribution is maintained throughout the compartment 14 due to the fan 72 which maintains active air circulation within it.

A sub-control panel 80 is provided near the top of the body 51 and has a variety of control buttons. A temperature control program is also stored in a memory within the sub-control panel.

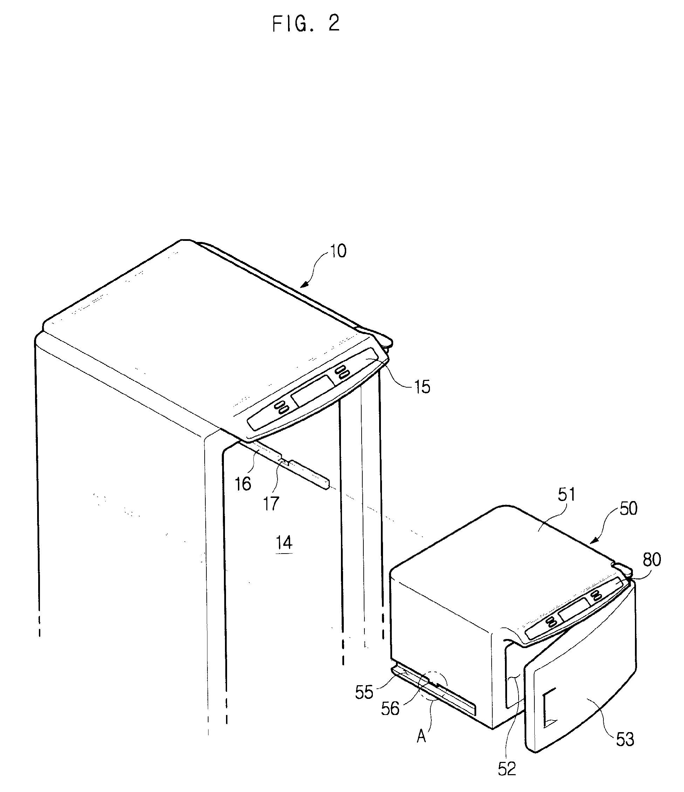

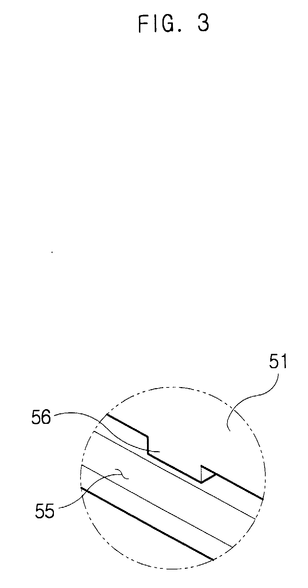

The small-sized sub-storage unit 50 is removable from the main compartment 14 of the storage box as shown in Figures 2 and 3 so that a user may use the sub-storage unit 50 independently from the storage box. To enable removal of the sub-storage unit 50 from the main compartment 14, a horizontal guide rail 16 is provided on the inner surfaces of each side wall of the inner casing 11 each of which co-operate with a corresponding guide channel 50 formed on the outer surface of each side wall of the body 50. A locking projection 56 is formed at the middle portion of each of the guide channels 55 which engages a locking notch 17 formed at the middle portion of each of the guide rails to lock the sub-storage unit 50 in place.

The sub-storage unit 50 may be independently operable within the main compartment 14 by turning on only the sub-storage unit 50 after installing it within the main compartment 14.

The sub-storage unit 50 may also be used after it has been removed from the main compartment 14 so that it can be used, for example, in a car. When the sub-storage unit 50 is removed from the main compartment 14, the rails 16 may be used to support a shelf (not shown).

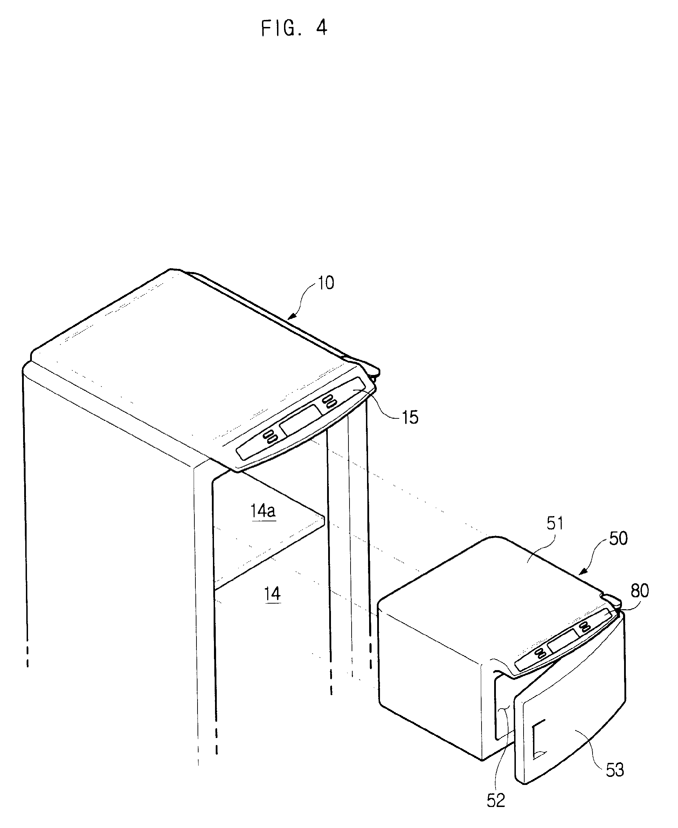

In Figure 2, another arrangement for removably supporting the sub-storage unit is illustrated. The main compartment 14 is partitioned by a horizontal partition wall to form a chamber 14a within the compartment 14 for receiving the sub-storage unit 50 in the chamber 14a as shown in Figure 4.

Operation of the storage box will now be described.

When the compartment 14 is operated in a cooling mode and the sub-storage unit 50 is installed within the compartment 14, the storage box is turned on by operating the main control panel 15 to apply DC voltages to the main thermoelectric element 60, thus starting the cool-storage mode operation of the main compartment 14. The first junction 21 of the main thermoelement 20 absorbs heat to keep the temperature of the main compartment 14 at about 3°C, and maintains said compartment in a cool-storage mode, whereas the second junction 22 of the main thermoelectric element 20 dissipates heat.

During the cold storage mode operation of the main compartment 14, the temperature difference between the areas around the two junctions 61 and 62 of the sub-thermoelectric element 60 is relatively smaller than that of the main thermoelectric element 20. The temperature compartment 52 in the storage unit is thus reduced lower than that of the main compartment 14 to be kept at a point lower than 0°C. Therefore the compartment 52 is kept at a freezing temperature.

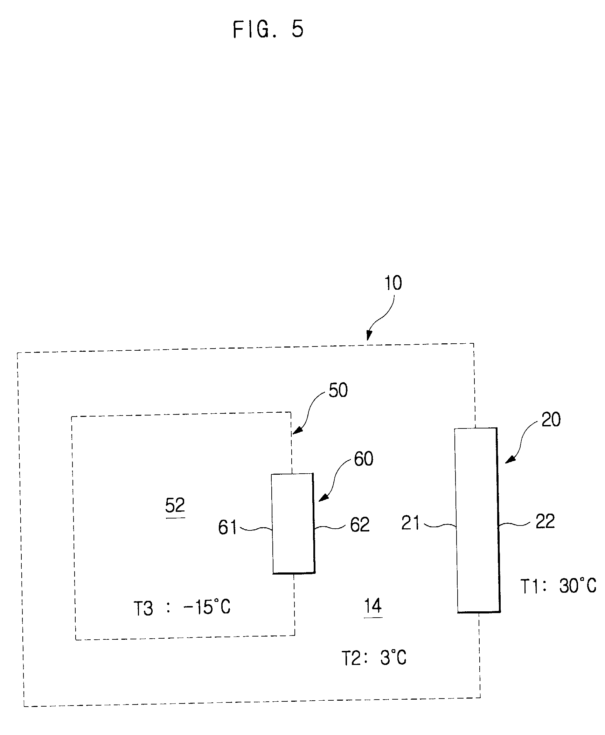

Referring now to Figure 5, the temperature T2 of the main compartment 14 is kept at about 3°C due to the operation of the main thermoelectric element 20 when the temperature T1 outside the cabinet 10 is about 30°C. This means that the temperature of the area around the second junction 62 of the sub-thermoelectric element 60 that acts as a heat dissipating junction is kept at about 3°C. The compartment 52 of the sub-storage unit 50 is thus reduced in its temperature T3 to about -15°C, and is kept in a frozen-storage mode.

This is caused by the fact that the temperature difference between the areas around the two junctions 61 and 62 of the sub-thermoelectric element 60 is relatively smaller than that of the main thermoelectric element 20 as described above. That is, the difference ΔT1 between the temperature T1 outside the cabinet 10 and the temperature T2 of the main compartment 14 is arithmetically calculated to 27°C. The difference ΔT2 between the temperature T2 of the main compartment 14 and the temperature T3 of the sub-compartment 52 is arithmetically calculated to 18°C.

However, the practical temperature difference between two junctions of each of the main and sub-thermoelectric element 20, 60 is calculated to about 43°C in case of the main thermoelectric element 20 and about 30°C in the case of sub-thermoelectric element 60 due to the additional heat generated by the heat exchanging units, such as heat dissipating unit 30 and the heat dissipating unit 70 which must be added to each arithmetic temperature difference. Therefore, the temperature difference ΔT2 between the areas around the two junctions 61 and 62 of the sub-thermoelectric element 60 is smaller than the temperature difference ΔT2 between the areas around the two junctions 21 and 22 of the main thermoelectric element 20.

To obtain a temperature of below freezing in the compartment 52 of the sub-storage unit 50, the main compartment 14 is partially cooled by the main thermoelectric element 20 prior to secondarily cooling the sub-storage unit's compartment 52 using the sub-thermoelectric element 60.

The heat dissipating unit 30 is positioned at the second junction 22 of the main thermoelectric element 20 and using a thermosiphon and consisting of the evaporator 31, the condensor 32 and the cooling fan 33, performs a heat dissipating action. At the second junction 62 of the sub-thermoelectric element 60, the heat dissipating unit 70 performs a heat dissipating action. In addition, the fan 72 of the sub-storage unit 50 actively and continuously circulates air of the main compartment 14, thus improving the operational efficiency of the heat dissipating unit 70 and maintaining a uniform temperature distribution throughout the compartment 14 regardless of area within the compartment 14.

The sub-storage unit 50 may be removed from the main compartment 14 by pulling it from the main compartment 14 while slightly raising it upward from the rails 16 after opening the door 40. The projections 56 of the channels 55 are released from the notches 17 in rails 16, thus allowing the sub-storage unit 50 to be removed from the main compartment 14 under the guidance rails 16.

When the sub-storage unit 50 is connected to an appropriate power source, such as the cigar lighter socket in a car, the unit 50 can be used as a cool-storage unit or a hot-storage unit in accordance with a direction of flow of DC voltage applied to the unit 50.

The storage box may be used as a cool-storage box or a hot-storage box independently from sub-storage unit 50 removed from the main compartment 14. That is, when a DC voltage is applied to the storage box such that the first junction 21 of the main thermoelectric element 20 acts as a heat dissipating junction and the second junction 22 acts as a heat absorbing junction, the main compartment 14 is operated in a hot-storage mode. However, when the direction of the electric current applied to the storage box is changed, the actions of the two junctions 21 and 22 of the main thermoelectric element 20 are reversed to allow the main compartment 14 as to act as a cool-storage compartment.

As described above, the present invention provides a storage box using a thermoelectric element. During a cool-storage mode operation, the main compartment is primarily cooled by a main thermoelectric element so the temperature difference between the areas around the two junctions of the sub-thermoelectric element of a sub-storage unit installed within the main compartment is sufficiently similar than that between the areas around the two junctions of the main thermoelectric element irrespective of a consideration of an addition of heat produced from heat exchanging units provided at the two junctions of each thermoelectric element. The sub-thermoelectric element of the sub-storage unit is thus significantly improved in its cooling capacity. The temperature of the sub-compartment of the sub-storage unit is thus reduced lower than 0°C, and so the sub-compartment is kept in a frozen-storage mode.

Although a preferred embodiment of the present invention has been described for illustration purposes, those skilled in the art will appreciate the various modifications, additions and submissions are possible, without departing from the scope of the invention as disclosed in the accompanying claims.

## Claims

1. A storage box comprising a housing (10) defining a first storage compartment (14) having a main thermoelectric (20) element associated therewith operable to cool the first storage compartment (14), **characterised by** a second housing (50) defining a second storage compartment (52) disposed within the first storage compartment (14) and having a second thermoelectric element (60) associated therewith operable to cool the second storage compartment (52) to a temperature lower than the temperature of the first storage compartment (14).

2. A storage box according to claim 1, wherein the second thermoelectric element (60) is operable to cool the second storage compartment (52) to a temperature which is lower than zero degrees centigrade.

3. A storage box according to claim 1 or claim 2, wherein a heat dissipating unit (70) is mounted on the outside of the second housing (50) within the first housing (10) to dissipate heat from the second storage compartment (52) into the first storage compartment (14).

4. A storage box according to claim 3, wherein a fan (72) is mounted adjacent to the heat dissipating unit (70) to assist in the transfer of heat from the heat dissipating unit (70) into the first storage compartment (14).

5. A storage box according to claim 3, wherein a second heat dissipating unit (30) is mounted on the outside of the first housing (10) to dissipate heat from the first storage compartment (14) to outside.

6. A storage box according to any preceding claim, wherein the first and second thermoelectric elements (20, 60) each comprise a Peltier element.

7. A storage box according to any preceding claim, wherein the second housing (50) is removably mounted in the first housing (10).

8. A storage box according to any preceding claim, wherein the first and second housings (10, 50) are each provided with a dedicated control unit (15, 80) to enable independent operation and control of the temperature within each housing (10, 50).

9. A storage box using a thermoelement comprising:
a cabinet defining a storage compartment therein;
a main thermoelement installed in a wall of the cabinet so as to allow the storage compartment to act as a cool-storage compartment or a hot-storage compartment; and
a sub-storage unit installed in said storage compartment, and having a sub-thermoelement so as to be operated in a frozen-storage mode through a multi-stage cooling operation during a cool-storage mode operation of said compartment.

10. The storage box according to claim 9, wherein said sub-storage unit comprises:
a body defining a sub-storage compartment therein and having the sub-thermoelement in its wall;
a door mounted to said body so as to open or close the sub-storage compartment; and
a heat dissipating unit provided at a heat dissipating junction of said sub-thermoelement.

11. The storage box according to claim 10, wherein a heat exchanging panel is arranged in the storage compartment of the cabinet to come into contact with a heat absorbing junction of said sub-thermoelement.

12. The storage box according to claim 10, wherein a fan is arranged in said body so as to allow the heat dissipating unit to evolve heat to air of the storage compartment of the cabinet.

13. The storage box according to claim 10, wherein means for detaching installing the body of the sub-storage unit within the storage compartment of the cabinet is provided at a junction of the body and an inner wall of the storage compartment of said cabinet.

14. The storage box according to claim 13, wherein said means comprises:
a rail horizontally provided on the inner surface of a storage compartment's sidewall of the cabinet; and
a channel provided on an outer surface of said body of the sub-storage unit for engaging with said rail.

15. The storage box according to claim 14, wherein a projection is provided on said channel, and a notch is formed on said rail to seat said projection therein when the sub-storage unit is installed in the storage compartment of the cabinet.

16. The storage box according to claim 10, wherein a chamber is provided in the storage compartment of the cabinet for seating the sub-storage unit therein.
